# EUROPEAN PATENT SPECIFICATION

(11) **EP 0 452 817 B1**
(45) Date of publication and mention of the grant of the patent: **11.10.1995**
(21) Application number: 91105804.8
(22) Date of filing: 11.04.1991
(51) Int. Cl.: H01L 29/10, H01L 21/266

(54) **Semiconductor device with MOS-transistors and method of manufacturing the same**
Halbleiterbauelement mit MOS-Transistoren und Verfahren zu dessen Herstellung
Dispositif à semiconducteur avec des transistors MOS et procédé pour sa fabrication

(30) Priority: 20.04.1990 JP 104580/90
(43) Date of publication of application: 23.10.1991
(73) Proprietor: KABUSHIKI KAISHA TOSHIBA, Kawasaki-shi, Kanagawa-ken 210 (JP)
(72) Inventor: Sawada, Shizuo, c/o Intellectual Property Division, Tokyo 105 (JP); Iwasaki, Seiko, c/o Intellectual Property Division, Tokyo 105 (JP)
(74) Representative: Lehn, Werner, Dipl.-Ing.

(56) References cited:
- PATENT ABSTRACTS OF JAPAN, vol. 11, no. 174 (E-513)(2621), 4 June 1987 & JP-A-628553
- I.E.E.E. TRANSACTIONS ON ELECTRON DEVICES, vol. ED-33, no. 3, March 1986, pp. 426-428, New York, NY ; R. STENGL et al. : "Variation of Lateral Doping as a Field Terminator for High-Voltage Power Devices"

## Description

The present invention relates to a semiconductor device and a method of manufacturing the same and, more particularly, to a semiconductor device and a method of manufacturing the same, which are suitably used when MOS transistors having different threshold voltages are to be obtained by a single step.

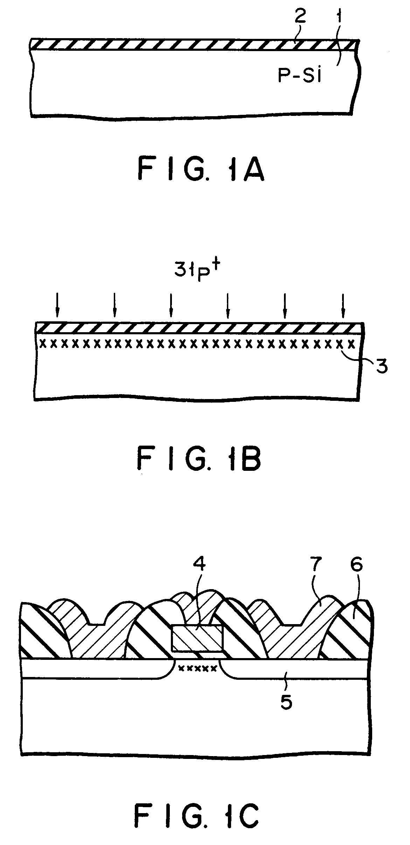

Conventionally, the threshold voltage of a MOS transistor and, more particularly, of a D-type (Depletion) transistor, is determined by the type and amount of an impurity used for the step of ion implantation in a channel, as shown in Figs. 1A to 1C. Fig. 1A shows a step of forming a gate insulating film 2 having a thickness of, e.g., 20nm (200 Å) on, e.g., a p-type semiconductor substrate 1. Fig. 1B shows a step of ion implantation in a channel for controlling the threshold voltage of a MOS transistor. In Fig. 1B, phosphorus ions 3 are implanted at an acceleration energy of 70 KeV to a concentration of about 1 × 10¹² cm⁻² in order to form, e.g., a depletion-type transistor. Fig. 1C shows a step of forming a gate electrode 4 and source and drain diffusion layers 5. In this case, when n-type polysilicon is used as the material of the gate electrode 4, the threshold voltage of the transistor is about -2 V. Reference numeral 6 denotes an insulating film; and 7, an aluminum wiring layer.

In this conventional example, however, when transistors having different threshold voltages are to be formed, different types of ions must be implanted in different amounts at different places in order to set different threshold voltages. In other words, the same number of photoengraving steps as that of the required threshold voltages are required, resulting in a great increase in the number of steps. A conventional well layer is obtained by performing impurity implantation through a considerably large opening of a mask pattern (opening diameter). Therefore, the conventional well have a uniform surface impurity concentration. To form transistors having different threshold voltages in the conventional well, it is also necessary to implant different types of ions in different amounts into the different parts of the well. In this case, too, the same number of photoengraving steps as that of the threshold voltages need to be performed.

From patent abstracts of Japan, volume 11, No. 174 (E-513) [2621-9] June 4, 1987 insulated gate FETs having different threshold voltages in the same type of well are known. The well region is formed by thermal diffusion in three dimensions, and a transistor is formed by using a region whose surface concentration is lowered.

The present invention has been made in view of the above situation and has as its object to provide a semiconductor device having different threshold voltages in a plurality of MOS transistors, and a method of manufacturing the same with fewer steps than in a conventional method.

This object is solved by a semiconductor device comprising a semiconductor substrate of one conductivity type, a MOS transistor formed in a surface of said semiconductor substrate and having source and drain layers of a conductivity type opposite to that of said semiconductor substrate, said MOS transistor further comprising a channel region formed under an insulated gate electrode between the source and drain regions, and a doped well layer formed in the channel region to control a threshold voltage of said MOS transistor, wherein said well layer has a substantially semicircular cross-section with respect to a plane perpendicular to said surface.

A semiconductor device according to the present invention comprises a semiconductor substrate of one conductivity type, a MOS transistor, formed in the semiconductor substrate and having source and drain layers of a conductivity type opposite to that of the semiconductor substrate, and a well layer formed in the vicinity of a channel region of the MOS transistor to control a threshold voltage thereof, wherein the well layer has a substantially semi-circular section with a non-flat lower surface. Also, a method of the present invention comprises the steps of forming a mask in which a mask pattern width of a portion corresponding to a mask opening diameter is equal to or less than twice the diffusion depth of a well layer, and implanting an impurity in a prospective channel portion of a MOS transistor of a semiconductor substrate by using the mask, thereby forming the well layer.

More specifically, according to the present invention, there is provided a semiconductor device having a well formed in a semiconductor substrate by setting the width of a portion of a mask pattern, used for impurity implantation, that corresponds to an opening diameter to be equal to or less than twice the diffusion depth of a well layer, and gate electrodes formed to have the well layer as a channel region of a MOS transistor. The well formed in the above manner has a substantially semi-circular section to facilitate impurity concentration control in the surface of the substrate (in the conventional well, since the impurity is implanted through a portion of a mask pattern having a considerably larger width than in the present invention, the surface concentration is uniform and it is difficult to control the threshold voltage). Furthermore, since a plurality of types of opening patterns having a small mask pattern width are formed in a single mask, MOS transistors having different threshold voltages can be formed in a single process

Moreover, the above object is solved by a method of manufacturing a semiconductor device, comprising the steps of manufacturing a mask having at least one opening, forming a well layer by implanting an impurity in a prospective channel region of a MOS transistor of a semiconductor substrate through said at least one opening, diffusing said impurity to a predetermined depth into said substrate, where said at least one opening has a dimension being not greater than twice said predetermined depth, and forming source and drain regions of said MOS transistor on opposite sides of said channel region.

This invention can be more fully understood from the following detailed description when taken in conjunction with the accompanying drawings, in which:
Figs. 1A to 1C show steps of manufacturing a conventional semiconductor device;
Figs. 2A to 2E show steps of manufacturing a semiconductor device according to an embodiment of the present invention;
Fig. 3A is a graph of resist space - diffusion depth characteristics used for explaining the embodiment of the present invention, and Fig. 3B is a graph of resist space - surface impurity concentration characteristics used for explaining the embodiment of the present invention;
Fig. 4A is a plan view of a pattern of another embodiment of the present invention, and Fig. 4B is a sectional view taken along the line A - A′ of Fig. 4A;
Fig. 5A is a plan view of a pattern of still another embodiment of the present invention, and
Fig. 5B is a sectional view taken along the line B - B of Fig. 5A; and
Fig. 6 is a schematic sectional view of still another embodiment of the present invention.

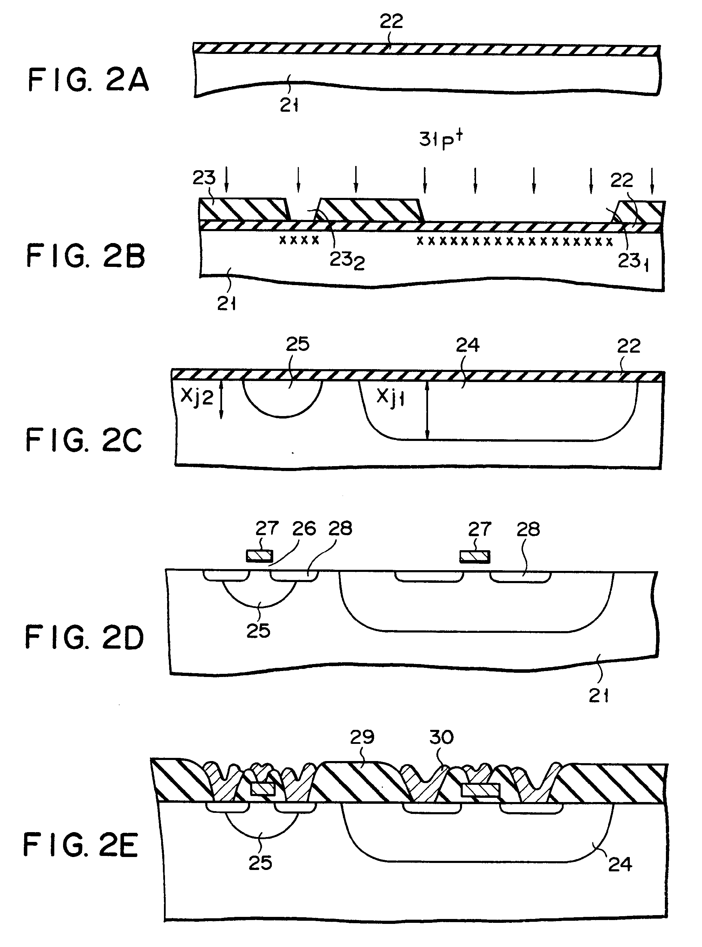

An embodiment of the present invention will be described with reference to Figs. 2A to 2E. First, as shown in Fig. 2A, a first thermal oxide film 22 is formed on a p-type substrate 21 having an impurity concentration of about 3 × 10¹⁵ cm⁻³. Subsequently, a resist mask 23 having resist patterns of different opening widths (mask pattern widths) is formed on prospective depletion-type transistor regions, as shown in Fig. 2B. Phosphorus ions are implanted in the substrate 21 at a dose of about 7 × 10¹³ cm⁻² and an acceleration energy of 70 KeV. The structure is then annealed at 1,150°C for about 4 hours to diffuse the phosphorus. As a result, a depth Xⱼ₁ of a diffusion layer 24 formed by phosphorus diffusion using a resist pattern 23₁ having a large width, e.g., 8 µm, is about 3 µm. The surface phosphorus concentration is about 3 × 10¹⁷ cm⁻³. However, a depth Xⱼ₂ of a well 25 formed by using a resist pattern 23₂ having a small width of 1 µm becomes 1 µm, and the surface concentration thereof is about 5 × 10¹⁶ cm⁻³.

Thereafter, the oxide film 22 is removed, and a gate insulating film 26 is deposited for about 200 Å. MOS transistor gate electrodes 27 are formed at portions corresponding to the resist patterns 23₁ and 23₂. Source and drain diffusion layers 28 are formed by, e.g., ion implantation. Then, an aluminum wiring layer 30 is formed over an insulating film 29 formed on the substrate as shown in Fig. 2E, thus completing MOS transistors.

The well 24 shown in Figs. 2C to 2E is formed using the resist pattern 23₁ having a mask width greatly larger than twice its diffusion depth Xⱼ₁ and corresponds to a conventional well. The well 25 is formed by using the resist pattern 23₂ having a mask width equal to or less than twice its diffusion depth Xⱼ₂. The well 25 has a substantially semi-circular section and is appropriate for threshold voltage control. This is because when a pattern opening diameter is small, the impurity concentration and the depth of a diffusion layer (especially that of an ion-implantation type) are determined by the pattern opening diameter. In this case, the length of the gate electrode on the well 25 in the channel lengthwise direction is also equal to or less than twice its well diffusion depth.

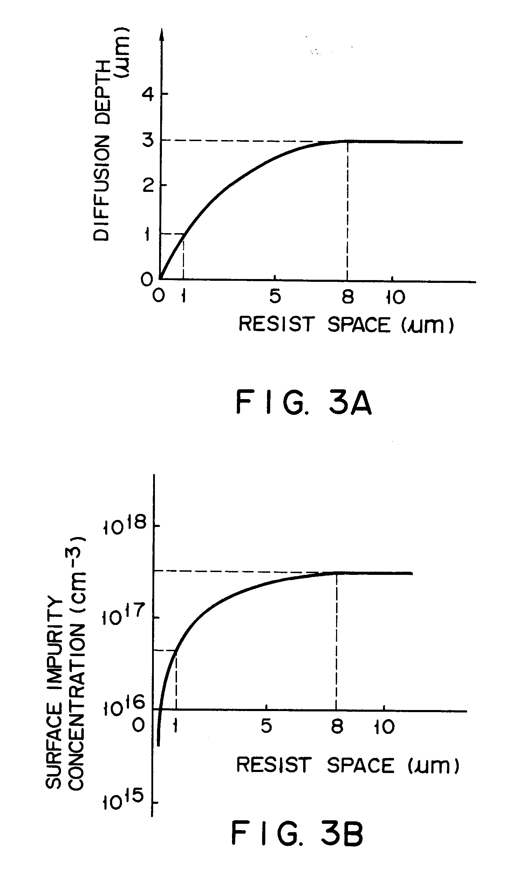

Fig. 3A shows the resist space (opening pattern width) - diffusion depth characteristics of this embodiment, and Fig. 3B shows the resist space - diffusion layer surface impurity concentration characteristics of the same. The surface impurity concentration influences the threshold voltage of the MOS transistor. As is apparent from Figs. 3A and 3B, when the opening pattern is set to have a width equal to or less than twice the diffusion depth, the surface impurity concentration is greatly reduced, and the diffusion depth becomes small. In other words, when the opening pattern width is set small, i.e., equal to or less than twice the diffusion depth, in the case of an n-channel MOS transistor, as in this embodiment, the threshold voltage can be changed in the positive direction (p-type impurity concentration is increased; n-type impurity concentration is decreased). When the pattern width becomes 0, the impurity concentration becomes identical to that of the p-type semiconductor substrate.

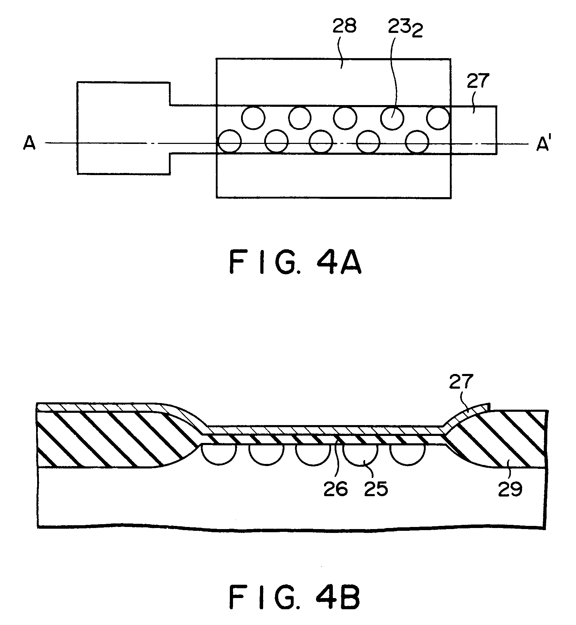

Fig. 4A is a plan view of a pattern according to another embodiment of the present invention, and Fig. 4B is a sectional view taken along the line A - A′ of Fig. 4A. The same reference numerals as in Figs. 2A to 2E denote the same or identical portions in Figs. 4A to 4B. In this embodiment, a plurality of mask patterns 23₂ for impurity implantation are arranged on the channel regions of the MOS transistors. In this case, the diameter of each mask pattern 23₂ is equal to or less than twice its diffusion depth. More specifically, a plurality of circular resist patterns 23₂ are formed in the channel regions of, e.g., MOS transistors, as shown in Fig. 4A. Phosphorus is implanted in these regions, and diffusion is subsequently performed to appropriately set the surface phosphorus concentration. As a result, the threshold voltages of the MOS transistors can be set.

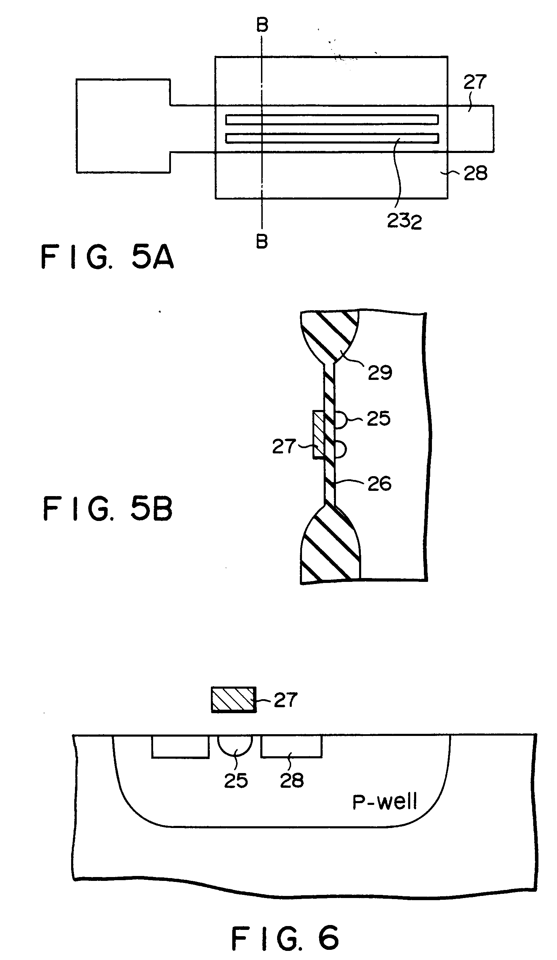

Another narrow diffusion layer pattern can be arranged to be perpendicular to the channel lengthwise direction. Fig. 5A is a plan view of a pattern of this example, and Fig. 5B is a sectional view taken along the line B - B of Fig. 5A. In this embodiment, e.g., two mask patterns 23₂ for impurity implantation are arranged parallel to the channel widthwise direction of the MOS transistors. In this case, the condition of the pattern width being equal to or less than twice the diffusion depth must apply only to the widthwise direction (shorter direction) of the mask patterns 23₂, and need not apply to the lengthwise direction.

Fig. 6 shows still another embodiment of the present invention. When the threshold voltage goes more toward the plus side than the case of Figs. 2A to 2E, a well 25 as shown in Fig. 6 may be adopted. The well 25 must similarly satisfy the above condition (the width must be equal to or less than twice the diffusion depth).

The present invention is not limited to the above embodiments but various changes and modifications can be made. For example, the shape of the mask pattern can be changed in various manners. In the above embodiments, the well is of a conductivity type opposite to that of the semiconductor substrate. However, the present invention can also be applied to an enhancement-type semiconductor device wherein the conductivity type of the well 25 is changed so that it will be of the same conductivity type as that of the substrate 21. In the above embodiments, the well has a "semi-circular" shape. However, it does not mean a true semi-circle but a shape whose bottom is not flat, unlike the well 24, but is curved, like the well 25.

According to the present invention, MOS transistors having different threshold voltages can be formed by the same manufacturing process (photoengraving steps) by forming a plurality of patterns having different opening diameters in a single mask, thus resulting in greatly simplified manufacturing steps.

Reference signs in the claims are intended for better understanding and shall not limit the scope.

## Claims

1. A semiconductor device comprising a semiconductor substrate (21) of one conductivity type, a MOS transistor formed in a surface of said semiconductor substrate and having source and drain layers (28) of a conductivity type opposite to that of said semiconductor substrate, said MOS transistor further comprising a channel region formed under an insulated gate electrode (27) between the source and drain regions, and a doped well layer (25) formed in the channel region to control a threshold voltage of said MOS transistor, wherein said well layer has a substantially semicircular cross-section with respect to a plane perpendicular to said surface.

2. A device according to claim 1,
characterized in that said well layer is of the same conductivity type as that of said source and drain layers of said MOS transistor.

3. A device according to claim 1,
characterized in that said well layer is of a conductivity type opposite to that of said source and drain layers of said MOS transistors.

4. A method of manufacturing a semiconductor device,
comprising the steps of manufacturing a mask (23) having at least one opening (23₂),forming a well layer (25) by implanting an impurity in a prospective channel region of a MOS transistor of a semiconductor substrate through said at least one opening, diffusing said impurity to a predetermined depth into said substrate, where said at least one opening has a dimension being not greater than twice said predetermined depth, and forming source and drain regions (28) of said MOS transistor on opposite sides of said channel region.

5. A method according to claim 4, further comprising the step of forming an insulated gate electrode (27) of said MOS transistor above said channel region, wherein the length of said gate electrode is not longer than twice said predetermined depth.

6. A method according to claim 4,
characterized in that a single mask has a plurality of said at least one opening.

7. A method according to claim 6,
characterized in that the mask also includes a second opening (23₁) with its dimensions being larger than twice said predetermined depth.

8. A method according to claim 4, further comprising the steps of forming an insulated gate electrode (27) above said channel region, forming said source and drain regions (28) by ion implantation using said gate electrode (27) as a mask.

9. A method according to claim 4,
characterized in that a plurality of said at least one opening are elongated in a direction perpendicular to the current-path in the channel region.

10. A method according to claim 4,
characterized in that a plurality of said at least one opening for impurity implantation are arranged on channel regions of a plurality of said MOS transistors.

11. A method according to claim 4,
characterized in that said well layer is of the same conductivity type as that of said source and drain layers.

12. A method according to claim 4,
characterized in that said well layer is of a conductivity type opposite to that of said source and drain layers.

## Patentansprüche

1. Halbleitervorrichtung mit einem Halbleitersubstrat (21) eines Leitfähigkeitstyps, einem MOS-Transistor, der in einer Oberfläche des Halbleitersubstrats gebildet ist, und Source- und Drainschichten (28) eines Leitfähigkeitstyps entgegengesetzt dem des Halbleitersubstrats aufweist, wobei der MOS-Transistor ferner ein Kanalgebiet umfaßt, das unter einer isolierten Gateelektrode (27) zwischen den Source- und Draingebieten gebildet ist, und eine dotierte Wannenschicht (25), die in dem Kanalgebiet gebildet ist, um eine Schwellenspannung des MOS-Transistors zu steuern, worin die Wannenschicht einen im wesentlichen halbkreisförmigen Querschnitt bezüglich einer Ebene senkrecht zu der Oberfläche hat.

2. Vorrichtung nach Anspruch 1, dadurch gekennzeichnet, daß die Wannenschicht denselben Leitfähigkeitstyp hat wie der der Source- und Drainschichten des MOS-Transistors.

3. Vorrichtung nach Anspruch 1, dadurch gekennzeichnet, daß die Wannenschicht einen Leitfähigkeitstyp entgegengesetzt dem der Source- und Drainschichten der MOS-Transistoren hat.

4. Verfahren zum Herstellen einer Halbleitervorrichtung, mit den Schritten Herstellen einer Maske (23) mit wenigstens einer Öffnung (23₂), Bilden einer Wannenschicht (25) mittels Implantieren einer Verunreinigung in einem zukünftigen Kanalgebiet eines MOS-Transistors eines Halbleitersubstrats durch die wenigstens eine Öffnung, Diffundieren der Verunreinigung bis zu einer vorbestimmten Tiefe in das Substrat, wo die wenigstens eine Öffnung eine Abmessung nicht größer als das Zweifache der vorbestimmten Tiefe hat, und Bilden von Source- und Draingebieten (28) des MOS-Transistors auf gegenüberliegenden Seiten des Kanalgebietes.

5. Verfahren nach Anspruch 4, gekennzeichnet durch Bilden einer isolierten Gateelektrode (27) des MOS-Transistors oberhalb des Kanalgebietes, worin die Länge der Gateelektrode nicht länger als das Zweifache der vorbestimmten Tiefe ist.

6. Verfahren nach Anspruch 4, dadurch gekennzeichnet, daß eine einzelne Maske eine Vielzahl der wenigstens einen Öffnung aufweist.

7. Verfahren nach Anspruch 6, dadurch gekennzeichnet, daß die Maske ebenfalls eine zweite Öffnung (23₁) einschließt, deren Abmessungen größer als das Zweifache der vorbestimmten Tiefe sind.

8. Verfahren nach Anspruch 4, gekennzeichnet durch Bilden einer isolierten Gateelektrode (27) oberhalb des Kanalgebietes, Bilden der Source- und Draingebiete (28) mittels Ionenimplantation unter Verwendung der Gateelektrode (27) als eine Maske.

9. Verfahren nach Anspruch 4, dadurch gekennzeichnet, daß eine Vielzahl der wenigstens einen Öffnung in einer Richtung senkrecht zum Strompfad in dem Kanalgebiet verlängert sind.

10. Verfahren nach Anspruch 4, dadurch gekennzeichnet, daß eine Vielzahl der wenigstens einen Öffnung für Verunreinigungsimplantation auf Kanalgebieten einer Vielzahl der MOS-Transistoren angeordnet sind.

11. Verfahren nach Anspruch 4, dadurch gekennzeichnet, daß die Grabenschicht vom selben Leitfähigkeitstyp wie der der Source- und Drainschichten ist.

12. Verfahren nach Anspruch 4, dadurch gekennzeichnet, daß die Grabenschicht einen Leitfähigkeitstyp entgegengesetzt dem der Source- und Drainschichten hat.

## Revendications

1. Dispositif à semiconducteur comprenant un substrat semiconducteur (21) d'un premier type de conductivité, un transistor MOS formé dans une surface dudit substrat semiconducteur et comportant des couches de source et de drain (28) d'un type de conductivité opposé à celui dudit substrat semiconducteur, ledit transistor MOS comprenant en outre une région de canal formée sous une électrode de grille isolée (27) entre les régions de source et de drain, et une couche de puits dopée (25) formée dans la région de canal pour commander une tension de seuil dudit transistor MOS, dans lequel ladite couche de puits présente une section en coupe sensiblement semi-circulaire par rapport à un plan perpendiculaire à ladite surface.

2. Dispositif selon la revendication 1, caractérisé en ce que ladite couche de puits est du même type de conductivité que celui desdites couches de source et de drain dudit transistor MOS.

3. Dispositif selon la revendication 1, caractérisé en ce que ladite couche de puits est d'un type de conductivité opposé à celui desdites couches de source et de drain desdits transistors MOS.

4. Procédé de fabrication d'un dispositif à semiconducteur, comprenant les étapes de fabrication d'un masque (23) comportant au moins une ouverture (23₂), de formation d'une couche de puits (25) en implantant une impureté dans une région de canal prospective d'un transistor MOS d'un substrat semiconducteur au travers de ladite au moins une ouverture, de diffusion de ladite impureté jusqu'à une profondeur prédéterminée dans ledit substrat, où ladite au moins une ouverture présente une dimension non supérieure à deux fois ladite profondeur prédéterminée, et de formation de régions de source et de drain (28) dudit transistor MOS sur des côtés opposés de ladite région de canal.

5. Procédé selon la revendication 4, comprenant en outre l'étape de formation d'une électrode de grille isolée (27) dudit transistor MOS au-dessus de ladite région de canal, où la longueur de ladite électrode de grille n'est pas supérieure à deux fois ladite profondeur prédéterminée.

6. Procédé selon la revendication 4, caractérisé en ce qu'un unique masque comporte une pluralité de ladite au moins une ouverture.

7. Procédé selon la revendication 6, caractérisé en ce que le masque inclut également une seconde ouverture (23₁), ses dimensions étant supérieures à deux fois ladite profondeur prédéterminée.

8. Procédé selon la revendication 4, comprenant en outre les étapes de formation d'une électrode de grille isolée (27) au-dessus de ladite région de canal, de formation desdites régions de source et de drain (28) au moyen d'une implantation ionique qui utilise ladite électrode de grille (27) en tant que masque.

9. Procédé selon la revendication 4, caractérisé en ce qu'une pluralité de ladite au moins une ouverture sont allongées suivant une direction perpendiculaire à la voie de courant dans la région de canal.

10. Procédé selon la revendication 4, caractérisé en ce qu'une pluralité de ladite au moins une ouverture pour une implantation d'impuretés sont agencées sur des régions de canal d'une pluralité desdits transistors MOS.

11. Procédé selon la revendication 4, caractérisé en ce que ladite couche de puits est du même type de conductivité que celui desdites couches de source et de drain.

12. Procédé selon la revendication 4, caractérisé en ce que ladite couche de puits est d'un type de conductivité opposé à celui desdites couches de source et de drain.
